# EUROPEAN PATENT APPLICATION

(11) **EP 2 515 024 A2**
(43) Date of publication of application: **24.10.2012**
(21) Application number: 12164800.0
(22) Date of filing: 19.04.2012
(51) Int. Cl.: F16M 11/04

(54) **System for attaching a telematics device to a vehicle**

(30) Priority: 20.04.2011 FI 20115390
(71) Applicant: Aplicom OY, 44150 Aänekoski (FI)
(72) Inventor: Härmälä, Timo, FI-41120 PUUPPOLA (FI); Rosenström, Mikko, FI-43100 SAARIJÄRVI (FI)
(74) Representative: Laajalahti, Mika

(57) **Abstract**

According to one embodiment, the invention relates to a system (100) for attaching a telematics device to a vehicle, comprising a telematics device (110) provided with an antenna capable of being utilized in satellite positioning, and with a first external surface (120) towards which the antenna is at least partially directed, and a mounting bracket (150) provided with a mounting surface, first attachment elements for attaching the mounting bracket to a vehicle with the mounting surface directed towards the vehicle, and with second attachment elements (160) for attaching the telematics device to the mounting bracket, in which system the telematics device is additionally provided with a second external surface (130) with its contour matching the first external surface, and the second attachment elements being able to attach the telematics device optionally in such a way that the first external surface is directed towards the mounting surface or in such a way that the second external surface is directed towards the mounting surface.

## Description

### Object of the invention

The invention relates generally to a system for attaching a telematics device to a vehicle.

### Prior art

In the process of tracking and monitoring heavy-duty freight transport, information regarding the location of a vehicle is communicated, as necessary, to the vehicle's owner, the transport company or the like by making use of satellite positioning, such as for example GPS (global positioning system). It involves outfitting the vehicle with a GPS receiver, and with a transmitter sending location data to a control center either at regular intervals or in response to the fulfillment of specific transmission conditions. In practice, the control center can be a computer center of the vehicle's owner or the transport company, or a specialized service provider.

Patent publication US 6,129,321 describes one practice of mounting a display-equipped GPS device on a vehicle by means of a mounting pedestal. The GPS device can be rotated with respect to an axis of the mounting pedestal, thus enabling a release of the GPS device from the mounting pedestal with one hand.

Vehicle-mounted devices, which combine a receiver for satellite positioning and a transmitter for communicating information, are referred to as telematics devices. Typically, telematics devices carry out the transmission of information by way of data transfer provided by a mobile phone network. The use of telematics has established itself in the tracking of heavy-duty transport traffic and expanded to other vehicular applications, such as delivery traffic and various maintenance and care-taking services performed at a client's residence, as well as to private cars. The vast majority of vehicles subjected to tracking are equipped with a retrofitted telematics device. The increased popularity of telematics devices has been facilitated by general decrease in the price level of telematics equipment and by cost savings reached as a result of telematics equipment production quantities.

Automobile insurance companies and tax authorities may utilize the positioning of vehicles and the transmission of data in an effort to regulate the behavior of motorists. For example, the determination of insurance premiums can be set according to how much a vehicle is driven on known high-risk road sections, or the tax authority may institute a vehicle tax which depends on the use of an automobile and takes into consideration the mileage on congested roads and during rush hours.

### Summary

One objective of the invention is to provide an easy-to-use and efficient practice for attaching a retro-installable telematics device to a vehicle.

The one objective of the invention is achieved by a system of claim 1, a mounting bracket of claim 7, and by a telematics device of claim 8.

The system according to one embodiment of the invention for attaching a telematics device to a vehicle comprises a telematics device, which has an antenna capable of being utilized in satellite positioning and a first external surface towards which the antenna is at least partially directed, and a mounting bracket which has a mounting surface, first attachment elements for attaching the mounting bracket to a vehicle with the mounting surface directed towards the vehicle, and second attachment elements for attaching the telematics device to the mounting bracket, in which system the telematics device further has a second external surface with its contour matching the first external surface, and the second attachment elements being able to attach the telematics device optionally in such a way that the first external surface is directed towards the mounting surface or in such a way that the second external surface is directed towards the mounting surface.

The term "telematics device" is used in reference to devices, which combine a receiver for satellite positioning and a transmitter intended for communicating information. In the process of communicating information, such devices are capable of exploiting for example mobile phone networks.

The term "vehicle" is used for example in reference to various automobiles, such as cars, vans, trucks and/or trailer trucks, road or off-road working machines and/or vehicles, trains, boats or ships.

The term "external surface" is used in reference to an outer surface of the device, for example to the housing or some other physical external configuration of the device.

The term "mounting surface" is used in reference to that boundary surface of a telematics device mounting bracket which finds itself towards or against that part of the vehicle to which the mounting bracket will be attached. When the mounting bracket is attached to a vehicle, its mounting surface may be in direct contact with the vehicle and/or it can be in indirect contact with the vehicle with attachment elements and/or an air gap between the mounting surface and the vehicle. As far as a vehicle is concerned, the mounting surface refers to that particular surface to which the telematics device mounting bracket is directly or indirectly attached.

The mounting bracket according to one embodiment of the invention for attaching a telematics device to a vehicle comprises a mounting surface, first attachment elements for attaching the mounting bracket to the vehicle with the mounting surface directed towards the vehicle, and second attachment elements for attaching the telematics device to the mounting bracket, in which mounting bracket the second attachment elements are able to attach a telematics device in such a way that the telematics device has its first external surface, towards which an antenna capable of being utilized in satellite positioning is at least partially directed, optionally directed towards the mounting surface or away from the mounting surface.

The telematics device according to one embodiment of the invention comprises an antenna which is adapted to be utilized in satellite positioning, and a first external surface towards which the antenna is at least partially directed, said telematics device having additionally a second external surface with its contour matching the first external surface, whereby the telematics device can be attached to a vehicle by means of a mounting bracket optionally in such a way that the first external surface is directed towards a mounting surface of the vehicle or in such a way that the second external surface is directed towards a mounting surface of the vehicle.

Other embodiments of the invention are presented in dependent claims.

The attachment system according to embodiments of the invention enables implementing a quick and thereby economically sensible practice of removing and attaching a telematics device from and to a vehicle, because, as the cost level of retro-installable telematics devices becomes lower and their quantities increase, along with rising overall labor costs, the time spent for installing the same becomes a more and more significant cost factor.

The applications useful for insurance companies and tax authorities also impose specific demands regarding how to conduct the retrofitting of a telematics device. Indeed, the attachment system according to embodiments of the invention enables providing a reliable way of monitoring that the retro-installable telematics device has not been removed from a vehicle without authorization and ensuring that, except for maintenance operations, it is kept permanently on the same vehicle as the information communicated thereby makes a difference in the amount of charges or taxes levied on the automobile owner.

The increasingly common use of telematics devices in private cars increases also the demand for high level equipment design. Therefore, it is indeed beneficial that the attachment system according to embodiments of the invention makes it possible to design an aesthetically stylish retro-installable telematics device.

The attachment system according to embodiments of the invention also enables the reception of weak positioning signals, the use of which in satellite positioning technology utilized by telematics devices imposes its specific demands for the installation of telematics devices. The radio signals employed in satellite positioning are of very low strength and dampened by metal parts of a vehicle, and even by windshields provided with heating and glare protection. The device, which houses a satellite antenna or at least has a satellite antenna linked with the device, works best when placed in plain sight, for example on top of the vehicle dashboard or inside the windshield.

In addition, the attachment system according to embodiments of the invention enables the existing old telematics device to be readily replaced with a new one or to be subjected to maintenance, because, as the popularity of telematics devices increases, the significance of maintenance capability for devices already installed on vehicles increases as well. Hence, when the old telematics device is in maintenance or out of order, the attachment system according to the invention enables providing a replacement device quickly and conveniently.

Furthermore, the attachment system according to embodiments of the invention enables, as necessary, the old SIM card required for a mobile phone network connection to be easily and time-efficiently replaced with a new one, in which case the telematics device can be effortlessly released from the mounting bracket, which in turn can be retained in attachment with the vehicle the whole time.

### Description of the figures

The detailed description of the figures relates more precisely to exemplary embodiments of the invention with reference to the accompanying figures, in which
- fig. 1: shows a system for attaching a telematics device to a vehicle,
- fig. 2: shows how a telematics device is released from a mounting bracket, and
- figs. 3a-3b: show how a mounting bracket is attached to a vehicle and how the attachment is sealed.

### Detailed description of the figures

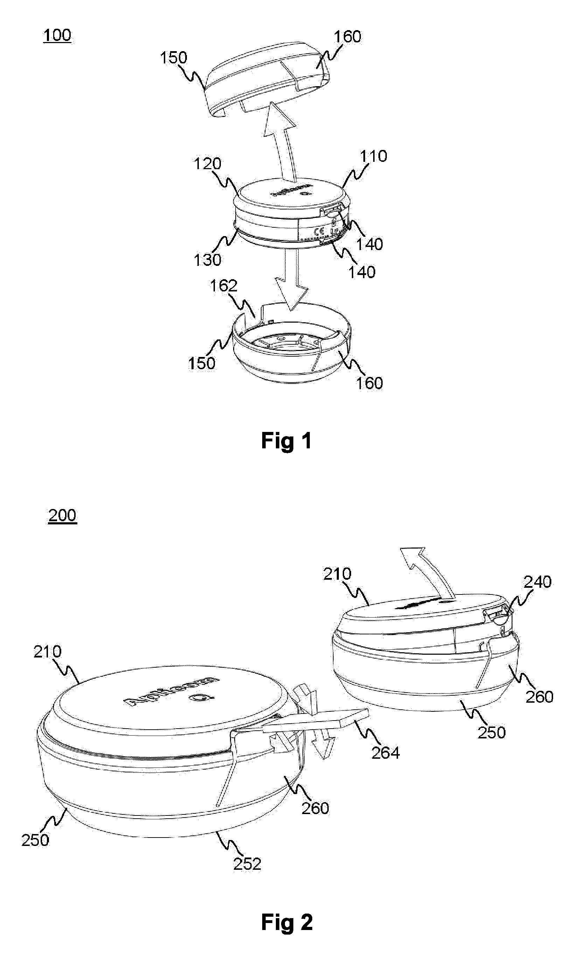

Fig. 1 depicts a system 100 for attaching a telematics device 110 to a vehicle (not shown in the figure). The telematics device housing consists of a top cover 120 and a bottom cover 130, which are capable of being fastened to each other removably or permanently and which are formed with recesses 140 enabling the telematics device 110 to be removably attached to a mounting bracket 150 and to the vehicle. The employed manufacturing material for the telematics device housing and the mounting bracket 140 comprises a material permeable to radio waves, for example (injection moldable) plastics or an appropriate composite material.

Inside the telematics device housing is incorporated its electronics, which consists for example at least of a processor, a memory, a SIM (subscriber identity module) unit, a GPS unit, and data transfer elements for communicating information for example by way of a mobile phone network wirelessly from the telematics device 110 for example to a vehicle control center.

The external surfaces of the top cover and the bottom cover are substantially similar in configuration, such that the telematics device 110 can be installed removably in the mounting bracket 150 as indicated by arrows in two mutually opposite positions, i.e. the top cover 120 or the bottom cover 130 against the mounting bracket's base, and locked in place by means of the telematics device's recess 140 and the mounting bracket's attachment element 160. On the other hand, the release of the telematics device 110 can be effected by using an opening 162 in the mounting bracket 150, by way of which extends the telematics device wiring while the telematics device 110 is held installed in the mounting bracket 150 and which facilitates taking a grip of the telematics device 110 upon its removal.

In a system according to one embodiment of the invention, as presented in any of the preceding embodiments, the second attachment elements are adapted to fasten the telematics device removably to the mounting bracket.

In a mounting bracket according to one embodiment of the invention, as presented in any of the preceding embodiments, the second attachment elements are adapted to fasten the telematics device removably to the mounting bracket. Alternatively, the telematics device 110 can be installed also permanently in the mounting bracket 150 as indicated by arrows in two mutually opposite positions, i.e. the top cover 120 or the bottom cover 130 against the mounting bracket's base, and locked permanently in place by means of one or more screws and/or fastening pins.

The foregoing enables such an installation of the assembly that the antenna of a GPS receiver, which is housed in the telematics device 110 and sensitive in a certain direction, is capable of being oriented upward or almost upward irrespective of whether the assembly is installed for example on the windshield (upper mounting bracket 150) or the dashboard (lower mounting bracket 150) of a vehicle. The upward orientation of a GPS antenna towards the sky creates best conditions for the reception of low power signals transmitted by GPS satellites and is therefore beneficial from the performance standpoint of the device.

Fig. 2 depicts how a telematics device 210 installed in an attachment system 200 is released from a mounting bracket 250.

The telematics device 210 is attached to the mounting bracket 250 without tools by pressing it towards the mounting bracket's base 252 to be set against a vehicle and functioning as a mounting surface, whereby the mounting bracket's flexible attachment element 260, for example a locking tab shown in the figure, yields and thereby, with its movement directed away from the mounting bracket's center, allows for pressing the telematics device 210 into the attachment with the mounting bracket 250. If necessary, the locking tab 260 can also have such a stiffness that its deflection requires the user's assistance. At the same time as the telematics device 210 is pressed against the mounting bracket's base 252, the locking tab 260 urges towards its original position and against the telematics device's recess 240, hence locking the telematics device 210 in place. The telematics device 210 may also be manufactured with several recesses 240 and the mounting bracket 250 respectively with a corresponding number of locking tabs 260. Alternatively, the locking tab 260 can be replaced by one or more locking pins, which in the attachment process penetrate into the recess 240, or by a claw-equipped latch bar hinged to the mounting bracket 250, whose claw is pressed into the recess 240 in the attachment process.

Releasing the telematics device 240 progresses in reverse sequence, likewise without tools, by inserting for example a finger nail into the recess 240 and by lifting the telematics device, as indicated by the arrow, while deflecting the locking tab 260 with another finger as necessary. Optionally, the detachment can be performed with a screwdriver 264 or the like at the recess 240 serving as a pry notch by prising as indicated by the arrows. In this case, the user inserts for example the head of a screwdriver into the recess 240 and lifts the telematics device, whereby the locking tab 260 bends as indicated by the arrow in such a way that the rim of the telematics device 210 close to the recess 240 rises, as indicated by the arrow, off the mounting bracket 250 and it is possible for the user to remove with his/her fingers the telematics device 210 completely from the mounting bracket 250. The detachment is also assisted by an opening (not shown in the figure), which is present in the mounting bracket 250 and intended for wiring, and which facilitates taking a grip of the telematics device 210 after its rim has been lifted off the mounting bracket 250 from the other side.

In a system according to one embodiment of the invention, as presented in any of the preceding embodiments, the second attachment elements comprise at least one flexible locking tab, which is adapted to deflect away from the center of the mounting bracket, a locking pin, which is adapted to move towards and away from the center of the mounting bracket, and/or a claw-equipped latch bar, which is adapted to pivot towards and away from the center of the mounting bracket.

In a mounting bracket according to one embodiment of the invention, as presented in any of the preceding embodiments, the second attachment elements comprise at least one flexible locking tab, which is adapted to deflect away from the center of the mounting bracket, a locking pin, which is adapted to move towards and away from the center of the mounting bracket, and/or a claw-equipped latch bar, which is adapted to pivot towards and away from the center of the mounting bracket.

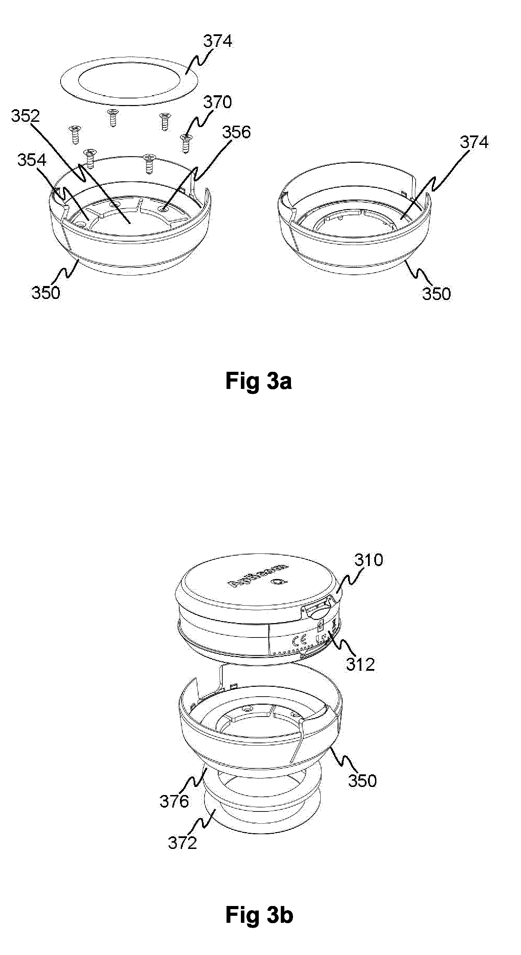

Figs. 3a and 3b depict how a mounting bracket 350 is attached to a vehicle with a screw attachment and an adhesive tape attachment, as well as how the attachment is sealed.

On the left in fig. 3a is visible a base section of the mounting bracket 350, i.e. a mounting surface 352, which consists of at least one flexible or rigid mounting tab 354, which is formed with at least one hole 356 located so as to leave it concealed underneath the device for an aesthetically pleasing appearance. In the illustrated example, the number of mounting tabs 354 and holes 356 therein is six. The circular design of the mounting bracket's base section 352 and the flexible mounting tabs 356 enable installation not only on flat surfaces but also for example on double-curved surfaces such as vehicle dashboards and windshields. The mounting bracket 350 can be attached to a vehicle by way of the holes 356 with screws 370, for example to the dashboard of a car, and the attachment can be sealed with a single sided sealing tape 374 applied on top of the screws 370 for preventing fraudulent uses as shown on the right of the figure.

In a system according to one embodiment of the invention, as presented in any of the preceding embodiments, the mounting bracket's mounting surface, which is circular in profile, is adapted to receive the telematics device's first external surface and second external surface, the profiles of which have been given a circular shape.

In a mounting bracket according to one embodiment of the invention, as presented in any of the preceding embodiments, the mounting bracket's mounting surface, which is circular in profile, is adapted to receive the telematics device's first external surface and second external surface, the profiles of which have been given a circular shape.

Alternatively, the mounting bracket 350 can be attached to a substrate, for example to the windshield of an automobile, with at least one double sided adhesive tape 372 as shown in fig. 3b, whereby a double sided sealing tape 376, which is examinable through the windshield, shall end up between the adhesive tape 372 and the mounting bracket 350. It is also possible that the sealing tape 376 be glued directly to the attachment with the windshield, and the mounting bracket 350, along with the adhesive tape 372 attached thereto, be respectively pressed into the attachment with the sealing tape 376 present on the windshield. Naturally, in connection with adhesive tape attachment, it is also possible to use the single sided sealing tape 374 the same way as in the case of screw attachment. Alternatively, the adhesive tape 372 and the seal make up a so-called hybrid adhesive tape, i.e. the double sided adhesive tape 372 would carry an integrated seal section on its windshield-facing side. Thus, in the process of detaching the mounting bracket 350, the sealing section of the hybrid adhesive tape would break down completely or would remain partly or completely stuck to the windshield, i.e. would be released partly or completely from the attachment section 372 of the hybrid adhesive tape with no possibility of switching the mounting bracket 350 inconspicu-ously to another vehicle.

In a system according to one embodiment of the invention, as presented in any of the preceding embodiments, the first attachment elements, which comprise one or more mounting tabs, are included in a mounting surface and are adapted by means of one or more screws and/or adhesive tapes to become attached to a vehicle.

In a mounting bracket according to one embodiment of the invention, as presented in any of the preceding embodiments, the first attachment elements, which comprise one or more mounting tabs, are included in a mounting surface and are adapted by means of one or more screws and/or adhesive tapes to become attached to a vehicle.

Communication between the telematics device 310 and the mounting bracket 350 is controllable by using for example a magnetic sealing tape 376 and by making use of a magnetic field sensor of the telematics device, which detects whether the telematics device 310 is disconnected from the mounting bracket 350 and from the magnetic sealing tape 376. Accordingly, for example a SIM card inserted in the telematics device 310 cannot be replaced without disrupting the seal.

Fig. 3b illustrates how the mounting bracket 350 covers a type plate 312 of the telematics device for improved aesthetic appearance of the attachment system when placed in the mounting bracket 350. In addition, the mounting bracket 350 covers a SIM card installation spot present in the telematics device 310, slots (not shown in the figure) for a service interface and/or a reset button both for aesthetic reasons and for protecting them at the same time from dust, physical mishaps, and abuse situations. On the opposite sides of a telematics device housing, on top of a junction between the top cover and the bottom cover, can also be applied tapes functioning as type plates provided for example with a serial number. The tapes are used either as actual type plates replacing the type plate 312 or optionally jointly together with the type plate 312. In addition, the tapes seal the telematics device components together at that particular parting line.

In a system according to one embodiment of the invention, as presented in any of the preceding embodiments, the mounting bracket has its outer rim adapted to cover at least one of the following set, consisting of a telematics device type plate, a SIM card installation spot, a service interface, and a reset button, while the telematics device is in attachment with the mounting bracket.

In a mounting bracket according to one embodiment of the invention, as presented in any of the preceding embodiments, the mounting bracket has its outer rim adapted to cover at least one of the following set, consisting of a telematics device type plate, a SIM card installation spot, a service interface, and a reset button, while the telematics device is in attachment with the mounting bracket.

Presented above are just a few embodiments for a solution of the invention. The principle according to the invention can naturally be modified within the scope of protection defined by the claims, regarding for example implementation details as well as fields of use.

## Claims

1. A system (100, 200) for attaching a telematics device to a vehicle, comprising
a telematics device (110, 210), which has an antenna capable of being utilized in satellite positioning and a first external surface (120), and
a mounting bracket (150, 250, 350), which has a mounting surface (352), first attachment elements (354) for attaching the mounting bracket to a vehicle with the mounting surface directed towards the vehicle, and second attachment elements (160, 260) for attaching the telematics device to the mounting bracket,
**characterized in that** the telematics device further has a second external surface (130) with its contour matching the first external surface, and the second attachment elements being able to attach the telematics device optionally in such a way that the first external surface is directed towards the mounting surface or in such a way that the second external surface is directed towards the mounting surface.

2. A system as set forth in claim 1, wherein the second attachment elements are adapted to attach the telematics device removably to the mounting bracket.

3. A system as set forth in claim 1 or 2, wherein the first attachment elements, which comprise a mounting tab (354), are included in the mounting surface and are adapted, by means of a screw (370) or an adhesive tape (372), to become attached to a vehicle.

4. A system as set forth in any of the preceding claims, wherein the second attachment elements comprise a locking tab (160, 260), which is adapted to deflect away from the center of the mounting bracket, a locking pin, which is adapted to move towards and away from the center of the mounting bracket, or a claw-equipped latch bar, which is adapted to pivot towards and away from the center of the mounting bracket.

5. A system as set forth in any of the preceding claims, wherein the mounting bracket has its mounting surface adapted to receive the first external surface and the second external surface, the profiles of which have been given a circular design.

6. A system as set forth in any of the preceding claims, wherein the mounting bracket has its outer rim adapted to cover a type plate (312), a SIM card installation spot, a service interface or a reset button of the telematics device while the telematics device is in attachment with the mounting bracket.

7. A mounting bracket (150, 250, 350) for attaching a telematics device to a vehicle, comprising
a mounting surface (352),
first attachment elements (354) for attaching the mounting bracket to a vehicle with the mounting surface directed towards the vehicle, and
second attachment elements (160, 260) for attaching the telematics device to the mounting bracket,
**characterized in that** the second attachment elements are able to attach a telematics device, which comprises an antenna capable of being utilized in satellite positioning, in such a way that the telematics device has its first external surface directed optionally towards the mounting surface or away from the mounting surface.

8. A telematics device (110, 210), comprising
an antenna, which is adapted to be utilized in satellite positioning, and
a first external surface (120),
**characterized in that** the telematics device has additionally a second external surface (130) with its contour matching the first external surface, whereby the telematics device can be attached to a vehicle by means of a mounting bracket optionally in such a way that the first external surface is directed towards a mounting surface of the vehicle or in such a way that the second external surface is directed towards a mounting surface of the vehicle.
